# EUROPEAN PATENT APPLICATION

(11) **EP 4 840 578 A1**
(43) Date of publication of application: **18.11.2026**
(21) Application number: 26173581.5
(22) Date of filing: 21.04.2026
(51) Int. Cl.: B23K 26/53, B23K 26/062, B23K 26/064, B23K 26/382, B23K 26/0622, B23K 101/40

(54) **DICING METHODS FOR IMPROVED DIE STRENGTH**

(30) Priority: 15.05.2025 US 202519209336
(71) Applicant: ASMPT Singapore Pte. Ltd., Singapore 768924 (SG)
(72) Inventor: NAUMOV, Alexander, 6641 TL Beuningen (NL); ZIJLSTRA, Niels, 6641 TL Beuningen (NL)
(74) Representative: Emerson, Peter James

(57) **Abstract**

A method of forming lines of weakness in a planar wafer having a plurality of devices formed thereon in a regular orthogonal array, the devices being spaced by channels, comprises irradiating the channels with at least one laser beam to weaken the planar wafer, wherein portions of the channels which are proximate to intersections of the channels are irradiated with a first average laser power, and portions of the channels which are intermediate the intersections are irradiated with a second, lower, average laser power.

## Description

This invention relates to methods of forming lines of weakness in a planar wafer and a dicing machine for forming lines of weakness, arranged in an orthogonal grid, in a planar wafer.

### BACKGROUND AND PRIOR ART

Singulation and scribing are well-known processes in the semiconductor industry, in which a cutting machine is used to work a workpiece or substrate such as a semiconductor wafer, which could for example comprise silicon but is not so limited, or metal and / or ceramic wafer. Throughout this specification, the term "wafer" is used to encompass all these products. In a singulation process (also referred to as dicing, severing, cleaving for example), a wafer is completely cut through such as to singulate the wafer into individual dies. In a scribing process (also referred to as grooving, scoring, gouging or furrowing for example), a channel or groove is cut into a wafer. Either of these processes may be performed mechanically, for example using a diamond saw, or using a laser-cutting approach, both of which are now well-established technologies.

Other processes may be applied subsequently, for example full singulation of scribed wafers by using a physical saw along the cut channels.

An alternative methodology, which is gaining in popularity, is the use of 'sub-surface dicing' (sometimes referred to as 'stealth dicing'). Such sub-surface dicing techniques are used to singulate dies of a wafer by internally modifying the wafer substrate material to form a line of weakness, and afterwards applying a mechanical force to induce a crack that separates the dies along the line of weakness.

Depending on the substrate material and the thickness thereof, one or multiple modification layers may be created along the line of weakness to weaken the material sufficiently to be able to induce the crack and separate the dies. Sub-surface dicing uses a reflective-type spatial light modulator (SLM) to create one or multiple modification layers in the substrate material simultaneously.

Additionally, the laser light may be modulated by the SLM such that the aberrations of the laser light are minimized at a predetermined position inside the substrate material.

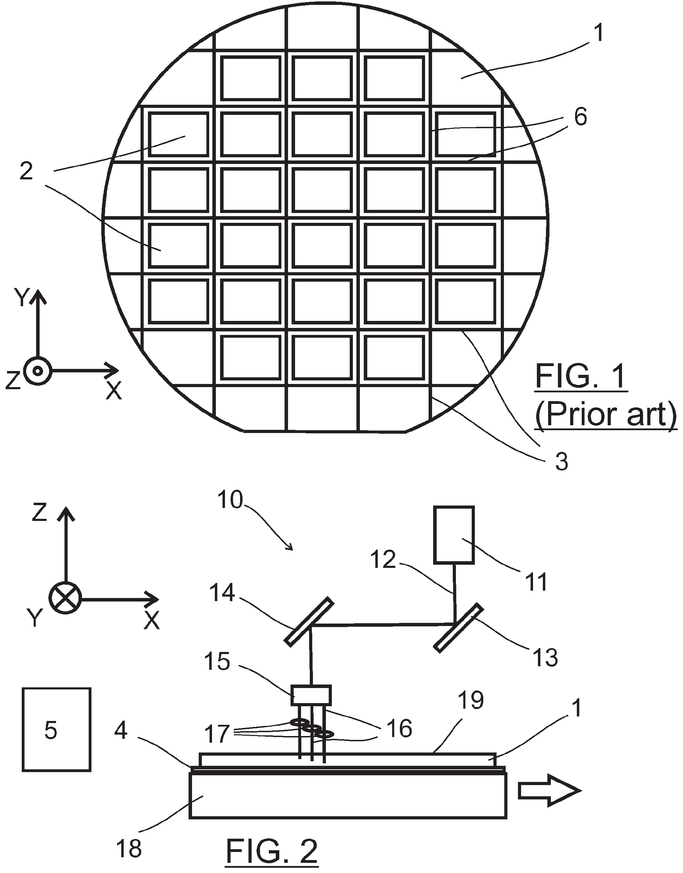

FIG. 1 schematically shows, from above, a substantially planar wafer 1 which has been processed using a sub-surface dicing process. As shown, the wafer 1 is provided with a plurality of electronics devices 2, which are arranged in a regular orthogonal array so that straight channels 6 extend between the devices 2. Sub-surface lines 3 are formed along these channels 6 using an incident laser which is directed to the interior of the wafer, so that each device 2 is partitioned from its neighboring devices 2 by a line 3. In other words, the lines 3 define an orthogonal grid. The wafer material proximate each line 3 is relatively weaker than the rest of the wafer material, in other words the lines 3 form lines of weakness in the planar wafer 1. It should be noted that in reality, the lines 3 would likely not be visible, and are shown for clarity of understanding only. A subsequent mechanical breaking step (not shown) may thereby physically separate the devices 2.

As exemplary prior art may be mentioned US10328521B2, EP2325689B1 and EP2186596B1.

Sub-surface dicing has various advantages, including the avoidance of kerf or heat losses, which may otherwise occur with laser-cutting techniques. In addition, there is no requirement to cool the wafer, e.g. with liquid coolant, and so the process is completely dry. Furthermore, sub-surface dicing is suitable for very thin wafers, which are becoming increasingly important in industry.

However, there are also associated disadvantages, in particular sub-surface dicing can lead to dies of lower strength, due to the modifications caused to the interior of the wafer material. These modifications weaken the sidewall and decrease the die strength.

The present invention seeks to provide an improved method of forming lines of weakness within a planar wafer, which is capable of producing dies with improved die strength.

In accordance with the present invention this aim is achieved by controlling the irradiation process such that irradiation is maximized proximate "crossings" or intersections of lines of weakness.

Such methods may be used both with sub-surface and surface scribing methodologies. In addition, the method may be extended to the use of drilling, as described further below.

### SUMMARY OF THE INVENTION

In accordance with a first aspect of the present invention there is provided a
method of forming a plurality of lines of weakness, arranged in an orthogonal grid, in a planar wafer in preparation for a mechanical breaking step which breaks the wafer along the lines of weakness, the method comprising the steps of:
irradiating portions of the planar wafer with at least one laser beam, each portion coinciding with a line of weakness to be formed in the planar wafer, the portions comprising:
   crossing portions which are located proximate intersections of the orthogonal grid, and
intermediate portions, which are located between adjacent crossing portions;
wherein the crossing portions are irradiated with a first average laser power, and
the intermediate portions are irradiated with a second average laser power; and
wherein the first average laser power is greater than the second average laser power.

In accordance with a second aspect of the present invention there is provided a method of forming lines of weakness in a planar wafer having a plurality of devices formed thereon in a regular orthogonal array, the devices being spaced by channels, the method comprising:
irradiating the channels with at least one laser beam to weaken the planar wafer,
wherein portions of the channels which are proximate to intersections of the channels are irradiated with a first average laser power,
and portions of the channels which are intermediate the intersections are irradiated with a second average laser power; and
wherein the first average laser power is greater than the second average laser power.

In accordance with a third aspect of the present invention there is provided a dicing machine for forming lines of weakness arranged in an orthogonal grid in a planar wafer, comprising:
a control means;
a laser irradiation means which is adapted to focus a laser beam towards the planar wafer; and
conveyance means for relatively moving the planar wafer and the laser irradiation means along a path parallel to the plane of the wafer;
wherein the control means is adapted to control the laser irradiation means and conveyance means to subject crossing portions of the planar wafer, which crossing portions are located proximate intersections of the orthogonal grid, to a first average laser power, and to subject intermediate portions of the planar wafer, which intermediate portions are located between adjacent crossing portions, to a second average laser power, and
wherein the first average laser power is greater than the second average laser power.

Other specific aspects and features of the present invention are set out in the accompanying claims.

### BRIEF DESCRIPTION OF THE DRAWINGS

The invention will now be described with reference to the accompanying drawings (not to scale), in which:
FIG. 1 schematically shows, from above, a wafer which has been subjected to a known sub-surface dicing process;
FIG. 2 schematically shows, from the side, an exemplary sub-surface dicing apparatus for use in performing the method of the present invention;
FIG. 3 schematically shows a wafer which has been subjected to a process in accordance with an embodiment of the present invention;
FIG. 4A schematically shows, from the side, a section of a wafer processed in accordance with the embodiment of FIG. 3, using a single laser beam;
FIG. 4B schematically shows, from the side, a section of a wafer processed in accordance with the embodiment of FIG. 3, using a plurality of sub-beams;
FIG. 5 schematically shows, from above, a wafer which has been subjected to a process in accordance with a second embodiment of the present invention;
FIG. 6A schematically shows, from the side, a section of a wafer processed in accordance with the embodiment of FIG. 5, using a single laser beam;
FIG. 6B schematically shows, from the side, a section of a wafer processed in accordance with the embodiment of FIG. 5, using a plurality of sub-beams;
FIG. 7 schematically shows, from above, a wafer which has been subjected to a process in accordance with a fourth embodiment of the present invention;
FIG. 8 schematically shows, in isometric view from above, an enlarged section of a wafer processed in accordance with the embodiment of FIG. 7;
FIG. 9 schematically shows, from above, a wafer which has been subjected to a process in accordance with a further embodiment of the present invention;
FIG. 10 schematically shows, from the side, a section of a wafer processed in accordance with the embodiment of FIG. 9;
FIG. 11 schematically shows, from above, a wafer which has been subjected to a process in accordance with a further embodiment of the present invention; and
FIG. 12 schematically shows, from the side, a section of a wafer processed in accordance with the embodiment of FIG. 11.

### DETAILED DESCRIPTION OF THE PREFERRED EMBODIMENTS OF THE INVENTION

FIG. 2 schematically shows, from the side, an exemplary sub-surface dicing apparatus 10 for use in performing the method of the present invention.

A laser source 11 is arranged to output a laser beam 12, which is directed along an optical path to the wafer 1 via first and second mirrors 13, 14. A beam shaper 15, such as diffractive optical element (DOE), spatial light modulator or the like, is positioned in the optical path to create an irradiation pattern of incident laser light comprising individual sub-beams 16. Each sub-beam 16 is focused by a respective focusing lens 17 to a focal point located within the wafer 1. Preferably, and as shown, each sub-beam 16 is focused to a respective focal point at a different respective depth of the wafer 1. The laser source 11 is selected so that the laser beam 12 produced thereby is capable of ablating the material of the wafer 1. For example, a suitable laser source 11 may produce a laser beam of wavelength in the range of about 1000 to 1500 nm, with:
i) a pulse duration in the range from about 1 ns to about 100 ns at around 5-50 kHz, and output power in the range from about 0.25W to about 2.5W; or
ii) about 0.25 ps to about 25 ps at around 5 to 50 kHz, and output power in the range from about 0.1W to about 2W.

In this embodiment, the wafer 1 and a flexible sheet 4 on which it is supported, are located on a chuck 18 which is drivable within the horizontal (X-Y) plane, as shown by the large arrow, and which therefore constitutes a conveyance means for relatively moving the planar wafer and the laser irradiation means along a path parallel to the plane of the wafer 1. The laser irradiation means or laser assembly, i.e. the laser source 11, mirrors 13, 14, beam shaper 15 and focusing lenses 17, is held stationary, while the chuck 10 moves the wafer 1 relative to the incident laser light along a path parallel to the plane of the wafer 1. This relative movement, in a translation direction along the path, while the wafer 1 is being irradiated by the incident laser light acts to create a line in the wafer 1 where the wafer material is modified by the irradiating light. Each such irradiation line corresponds to a line of weakness formed in the wafer 1.

In other embodiments (not shown), the wafer 1 may be held stationary while the laser beam 12 is translated, or both the wafer 1 and laser beam 12 are translated. In addition, while the apparatus 10 shown divides the laser beam 12 into three separate sub-beams 17, this is not necessary for the present invention - in fact only a single laser beam with a single respective focal point within the wafer 1 is required, but the use of such sub-beams, in various numbers, e.g. at least two sub-beams, may be advantageous in some circumstances.

The apparatus is provided with a control means 5, which may comprise, for example, a processor, computer or the like, and be located at the machine or remote but in communication therewith, for example cloud-based software, which controls the operation of the machine.

In accordance with the present invention, such apparatus may be used in the following way:
Firstly, it is necessary to determine locations of the planar wafer 1 at which lines of weakness are to be formed, and identifying a start location and an end location for each line of weakness. For this type of application, the lines of weakness are generally to be formed in the orthogonal grid pattern shown in FIG. 1, in which each line of weakness will be located equidistant between neighboring devices 2. The start and end point of each line of weakness will generally be at opposing edges of the wafer 1, meaning that a line of weakness is formed across the entire surface of the wafer 1.

The above-described apparatus is then used to relatively move the planar wafer 1 and the laser assembly along the path parallel to the plane of the wafer 1 from a position proximate the start location to a position proximate the end location of a respective line of weakness.

The above steps are standard in the art. However, in accordance with the present invention, while relatively moving the planar wafer 1 and the laser apparatus, the planar wafer 1 is subjected to a first average laser power along a first portion of the path and to a second average laser power along a second, non-overlapping, portion of the path, the first average laser power being greater than the second average laser power, so as to weaken the wafer 1 along the path between the start location and the end location.

Here, the term "average laser power" is used to denote a time-averaged laser power which is substantially independent of the pulse time and / or wavelength of the laser used. Commonly, the average laser power may be expressed in terms of the RMS or "root-mean-square" power of the laser beam.

It follows therefore that where the laser beam comprises a pulsed laser beam having a pulse period, the first portion is irradiated for a first time period, the second portion is irradiated for a second time period, and both the first and second time periods are greater than the pulse period.

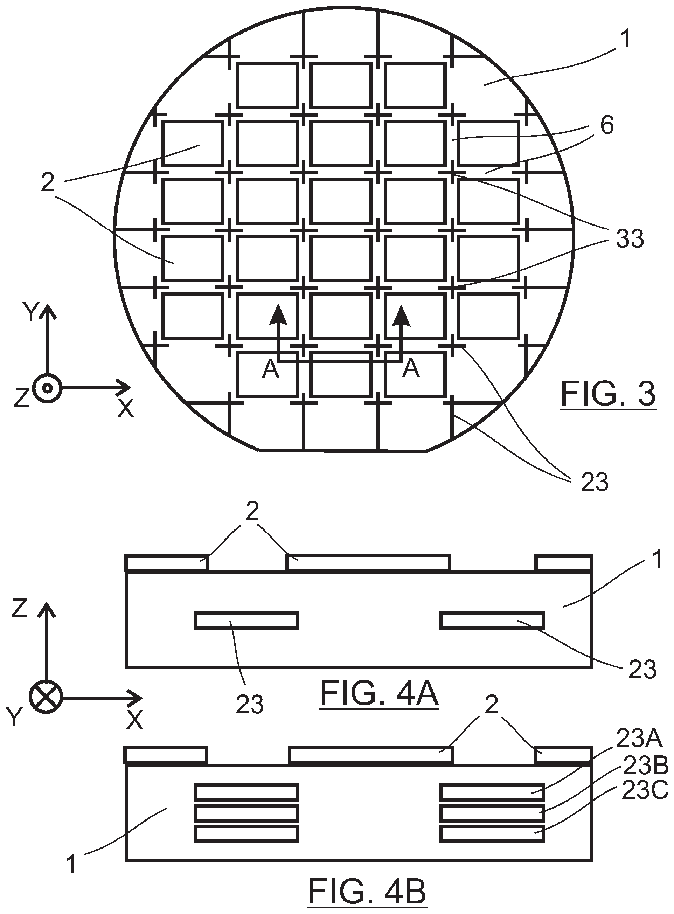

Within the scope of this method, there are various types of lines of weakness that may be formed. Certain fundamental examples will now be described with reference to Figs. 3 to 8.

In the following discussion, for clarity of understanding:
- The term "path" refers to the path of relative travel between the wafer 1 and the laser apparatus;
- The term "channel" refers to the elongate gaps between rows and columns of devices within an orthogonal array;
- The term "line of weakness" refers to an entire line of the wafer 1 which follows the path. Importantly, the line of weakness does not necessarily include regions of the wafer 1 which are modified by irradiating laser light along the entirety of the line of weakness; and
- The term "irradiation line" refers to a portion of a line of weakness in which laser light is irradiated into the wafer 1.

Therefore, a line of weakness in this context may include a plurality of non-overlapping individual irradiation lines.

A planar wafer 1 which has been processed by a sub-surface dicing method according to a first embodiment of the present invention is shown in FIG. 3. For consistency, the wafer 1 shown is similar to that of FIG. 1, having an identical orthogonal array of devices 2 located thereon, separated by channels 6. In this embodiment, a plurality of lines of weakness, coinciding with the channels 6, are produced using a sub-surface dicing process as explained in more detail below, and repeated in different locations of the wafer 1 as required to again form an orthogonal grid. However, in this embodiment, in the central region of the wafer 1, laser energy is only applied to the wafer 1 in first portions of the channels 6 / lines of weakness, i.e. at irradiation lines 23, at crossing portions 33 of the orthogonal grid, i.e. regions of the orthogonal grid where lines of weakness extending parallel to the Y axis shown intersect lines of weakness extending parallel to the X axis shown, the X and Y axes being mutually orthogonal and extending parallel to the plane of the wafer 1, so as to form a cruciform shape. Each crossing portion 33 is thereby located proximate a corner of at least one adjacent device 2, but spaced away from portions of the line of weakness (hereafter "intermediate portions") lying directly between adjacent devices 2 within a row or column. It should be noted that in reality, the irradiation lines 23, crossing portions 33 would likely not be visible, and are shown for clarity of understanding only. By limiting the extent of the irradiation lines 23 in this way, little to no damage is caused to the wafer 1 in areas directly between adjacent devices 2, i.e. at the intermediate portions, however it has been found that even with such a reduced total length of irradiation line 23 along the line of weakness, satisfactory separation of the dies is still possible. In this central area, the irradiated portion may be around 20% to 50% of the intended die size.

In FIG. 3, in the outer area of the wafer 1, i.e. proximate to its outer edge in the region between the outer edge and the radially outermost device 2, the irradiation lines 23 remain fully formed, since this aids separation without affecting the die strength in locations proximate any devices 2. This configuration is entirely optional though, and in other embodiments this outer area might not be so processed.

FIG. 4A schematically shows, from the side, a section of the wafer 1 processed in accordance with the embodiment of FIG. 3, using a single laser beam. More particularly, the section of wafer 1 shown in FIG. 4A is taken from the central area of the wafer 1, along the line A-A shown in FIG. 3, which includes a section of the closest line of weakness. It can be seen that the irradiation lines 23 are wholly within the body of the wafer 1, i.e. wholly internal and spaced from both the top and bottom surfaces of the wafer 1. Furthermore, the irradiation lines 23 are predominantly located away from the respective devices 2, so that there is little lateral overlap between irradiation lines 23 and devices 2. In some embodiments (not shown) indeed, there may be no overlap required at all, which may be possible depending on, for example, the thickness and material of the wafer 1. In addition, in this embodiment, there is no, i.e. zero, irradiation of the wafer in the portions of the path or line of weakness between adjacent irradiation lines 23 (i.e. the intermediate portions). To make this absolutely clear, each irradiation line 23 comprises a first portion, i.e. the crossing portion, of the path / line of weakness / channel 6 in which the wafer 1 is subjected to a relatively high average laser power, while at the portions of the path between each irradiation line 23 (i.e. the intermediate portions), the wafer 1 is subjected to a relatively low average laser power, here zero. Furthermore, the path comprises a plurality of first, crossing portions (the irradiation lines 23) interleaved with a plurality of second, intermediate portions.

FIG. 4B schematically shows, from the side, a section of the wafer 1 processed in accordance with the embodiment of FIG. 3, using a plurality of sub-beams 16, in a view analogous to that of FIG. 4A. In this case, apparatus 10 similar to that shown in FIG. 2 may be used to split the laser beam 12 output by the laser source 11 into three sub-beams 16, each focused to a different depth of the wafer 1, creating vertically spaced irradiation lines 23A, 23B, 23C. The irradiation schedule is otherwise similar to that of FIG. 4A. Different numbers of sub-beams may be used as appropriate.

In this embodiment, where the average laser energy applied to the wafer in the intermediate portions is zero, this may be achieved in various ways. For example, one possibility is to directly modulate the output power of the laser source 11 to change the average laser power output by the laser source 11. In this case, where the average laser power at the intermediate portions is zero, this is akin to turning the laser source 11 off for these portions of the path. An alternative possibility is to provide a beam modulator interposed in the optical path of the generated laser beam 12 between the laser source 11 and the focal point inside the wafer 1. The average laser power of the generated laser beam 12 may then be changed by controlling the beam modulator. Suitable beam modulators can be used for this purpose. A simple mechanical example could for example comprise a so-called "optical chopper", which may comprise a spinning opaque disc with a light-transparent window in a sector thereof, which disc may be placed in the optical path and caused to spin such that the light-transparent sector cyclically moves into and out of the optical path. When the laser beam 12 is incident upon the light-transparent sector substantially all of the laser energy is transmitted therethrough, but when the laser beam 12 is incident on part of the disc away from the segment, the laser beam 12 is blocked, and no laser energy is transmitted therethrough. Other forms of lovable light barriers may equally be used. The laser beam 12 may be equivalently modulated using other tools, such as switchable optical elements, beam shapers, beam diverters and the like.

Both of these modulation techniques may also be used to permit non-zero average laser power to be provided to the wafer 1 at the intermediate portions, which average laser power is reduced compared to that received by the wafer 1 at the crossing portions. For example, a disc similar to that described above may be used, in which a partially-light-transparent segment is provided, so that some, but not all, of the incident laser energy is scattered. Again, other modulation means can equally be used to provide the required non-zero average laser power, as is well-known in the art per se.

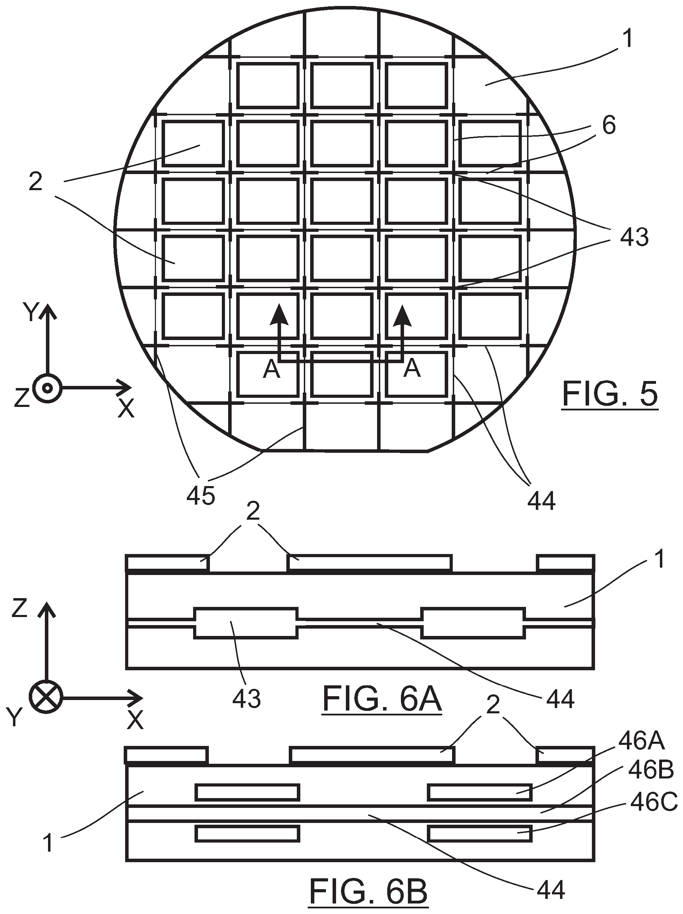

Fig. 5 shows a planar wafer 1 which has been processed by a method according to a second embodiment of the present invention. For consistency, the wafer 1 shown is similar to that of FIG. 1, having an identical orthogonal array of devices 2 located thereon, separated by channels 6. In this embodiment, a plurality of lines of weakness, coinciding with the channels 6, are produced using a sub-surface dicing process as explained in more detail below, and repeated in different locations of the wafer 1 as required to again form an orthogonal grid. In this embodiment, in the central region of the wafer 1, a relatively high average laser power is applied to the wafer 1 in first portions of the lines of weakness at crossing portions 43 of the orthogonal grid, i.e. regions of the orthogonal grid where lines of weakness extending parallel to the Y axis shown intersect lines of weakness extending parallel to the X axis shown, the X and Y axes being mutually orthogonal and extending parallel to the plane of the wafer 1 (i.e. similar to the crossing portions 33 of FIG. 3). In the second portions 44 of the path, lying between adjacent crossing portions 43 in a line of weakness, a relatively low average laser power is applied to the wafer 1. By limiting the extent of the relatively high power irradiation in this way, little to no damage is caused to the wafer 1 in areas directly between adjacent devices 2. However, the application of non-zero average laser power in the intermediate portions 44 aids breakage of the wafer 1, compared to the embodiment shown in FIG. 3.

It should be noted that in reality, the lines of weakness would likely not be visible, and are shown for clarity of understanding only.

In FIG. 5, in the outer area of the wafer 1, i.e. proximate to its outer edge in the region between the outer edge and the radially outermost device 2, irradiation lines 45, which are formed using relatively high average laser power, are formed, since this aids separation without affecting the die strength in locations proximate any devices 2. This configuration is entirely optional though, and in other embodiments this outer area may not be so processed.

FIG. 6A schematically shows, from the side, a section of the wafer 1 processed in accordance with the embodiment of FIG. 5, using a single laser beam, or alternatively multiple laser beams, and an alternative laser power modulation methodology to those described above. More particularly, the section of wafer 1 shown in FIG. 6A is taken from the central area of the wafer 1, along the line A-A shown in FIG. 5, which includes a section of the closest line of weakness. It can be seen that the line of weakness is wholly within the body of the wafer 1, i.e. wholly internal and spaced from both the top and bottom surfaces of the wafer 1. Furthermore, the first portions of relatively high average power, i.e. at crossing portions 43, are predominantly located away from the respective devices 2, so that there is little lateral overlap between crossing portions 43 and devices 2. In some embodiments (not shown) indeed, there may be no overlap required at all, which may be possible depending on, for example, the thickness and material of the wafer 1. In this embodiment, there is some, relatively low power, irradiation of the intermediate portions 44, between adjacent crossing portions 43.

In this embodiment, such power modulation between the crossing and intermediate portions may be achieved not by modulating the power of the laser beam 12 or laser 11 (which may both remain constant throughout), but by modulating the relative speed of movement between the wafer 1 and laser irradiation means, i.e. parallel to the X axis shown in FIG. 5 for the line of weakness shown in FIG. 6A. In more detail, the speed of relative movement may be made lower along the crossing portions of the path than along the intermediate portions of the path, by suitable control of the conveyance means by the control means. In this way, the laser energy received per unit length in the crossing portions 43 will be greater than in the intermediate portions 44.

FIG. 6B schematically shows, from the side, a section of the wafer 1 processed in accordance with the embodiment of FIG. 5, using a plurality of sub-beams 16, in a view analogous to that of FIG.6A. In this case, apparatus 10 similar to that shown in FIG. 2 may be used to split the laser beam 12 output by the laser source 11 into three sub-beams 16, each focused to a different depth of the wafer 1, creating vertically spaced irradiation lines 46A-C. In this embodiment, one of the sub-beams 16, responsible for forming the irradiation line 46B, is kept constantly on, at a constant average laser power, over the entirety of the path. However, the other sub-beams 16, responsible for forming the irradiation lines 46A, 46C, are modulated so as to only apply a non-zero average laser power at the first portions, and a zero average laser power at the second portions 44. This modulation may for example be achieved by using modulation means in the optical path of the respective sub-beams 16, as described generally above. This arrangement will again create a line of weakness with interleaved crossing portions and intermediate portions of the path where the total average laser power applied to the wafer 1 is greater at the crossing portions than at the intermediate portions 44.

The embodiments described so far relate to sub-surface dicing methodologies, in which the irradiating laser beams are focused within the interior of the wafer. However, the present invention is not so limited, and the following two embodiments described use alternative methodologies.

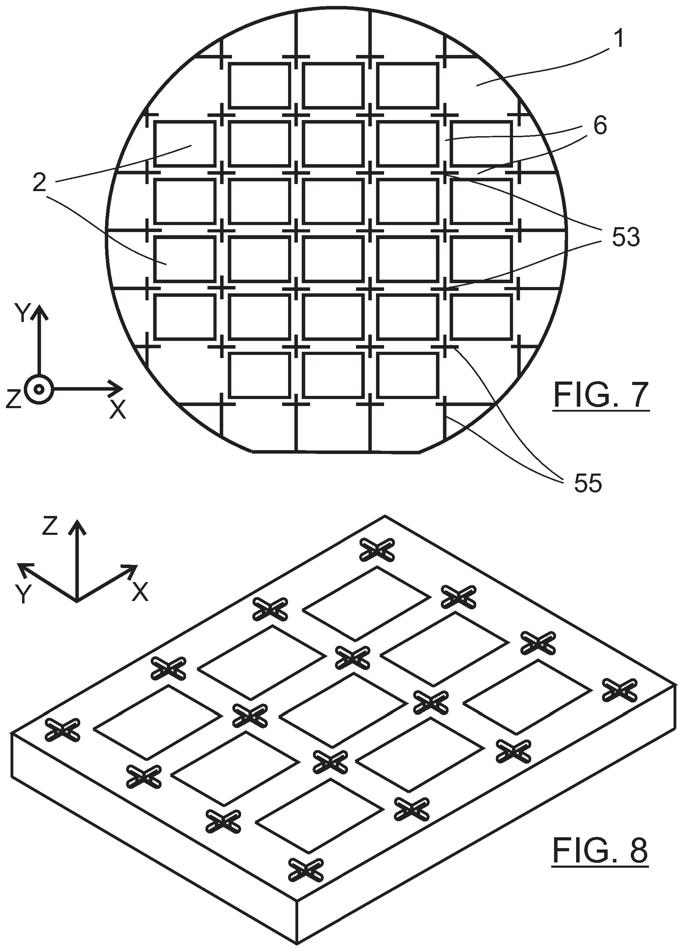

FIG. 7 schematically shows, from above, a wafer 1 which has been subjected to a process in accordance with a fourth embodiment of the present invention, while FIG. 8 schematically shows, in isometric view from above, a magnified section of the wafer 1. In this embodiment, a surface scribing technique is used. Surface scribing using lasers is well-known per se, and in such techniques an irradiating laser beam (or a plurality of laser beams) is directed to an upper surface of the wafer, causing a groove to be formed which extends into the body of the wafer, but does not extend through the entire thickness of the wafer. For this type of scribing process, a UV laser source may be used, as is well-known in the art per se. Apart from being formed proximate the upper surface of the wafer 1 rather than within it, this embodiment is similar to that of FIG. 3, such that a laser beam (or a plurality of laser beams) is used to form irradiation lines 55 coincident with channels 6 which, within a central region of the wafer 1, form crossing portions 53. As with that embodiment, the crossing portions 53 are regions of the orthogonal grid where lines of weakness extending parallel to the Y axis shown intersect lines of weakness extending parallel to the X axis shown, the X and Y axes being mutually orthogonal and extending parallel to the plane of the wafer 1, so as to form a cruciform shape. The crossing portions 53 are located proximate a corner of at least one adjacent device 2, but spaced away from intermediate portions of the line of weakness lying directly between adjacent devices 2 within a row or column.

In FIG. 7, in the outer area of the wafer 1, i.e. proximate to its outer edge in the region between the outer edge and the radially outermost device 2, the irradiation lines 55 remain fully formed, since this aids separation without affecting the die strength in locations proximate any devices 2. This configuration is entirely optional though, and in other embodiments this outer area may not be so processed.

In a related embodiment (not shown), a methodology similar to that described above with reference to FIG. 5 may be used. In other words, the crossing portions 53 may be formed using an irradiating laser beam or beams of relatively high average power, while the remaining intermediate sections of the lines of weakness may be formed using an irradiating laser beam or beams of relatively low average laser power. This may be achieved in various ways. For example, if a plurality of irradiating laser beams are used to create the crossing portions 53, one or more of this plurality may be "switched off" when scribing the intermediate regions of the lines of weakness (similarly to the embodiment of FIG.6B), or the laser may be modulated so that there is a reduction in irradiation power at these intermediate regions (similarly to the embodiment of FIG. 6A).

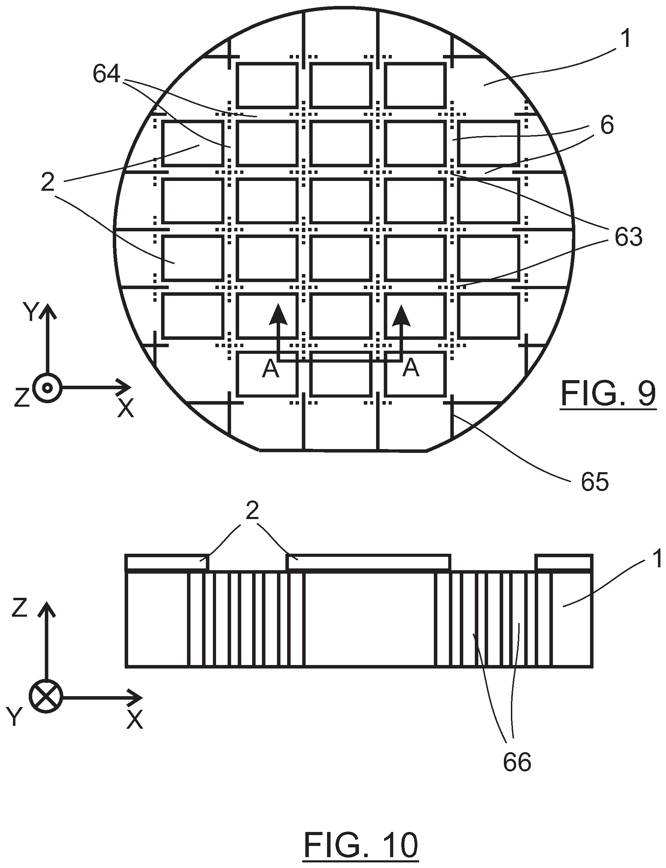

FIG. 9 schematically shows, from above, a wafer 1 which has been subjected to a process in accordance with a further embodiment of the present invention, while FIG. 10 schematically shows, from the side, a section of the wafer 1.

In this embodiment, crossing portions 63 are each formed from a plurality of discrete, closely spaced, individual drill holes 66. As shown in FIG. 10, each drill hole 66 may extend through the entire thickness of the wafer 1. The drill holes 66 are formed by laser drilling. As is well-known in the art per se, laser drilling may be achieved by directing a laser beam such that it irradiates a point of wafer 1 with a laser beam while there is no relative movement between the wafer 1 and the laser beam. As is well-known in the art per se, a UV laser source may be used for such drilling processes. In practice, the drill holes 66 thus produced may not have sides quite as parallel as shown in FIG. 10, which shows an idealized drill-cut wafer 1. Following drilling of a first drill hole 66 at a first point at a crossing portion 63, the planar wafer 1 is repositioned relative to the laser irradiation means so that the laser beam is directed towards a second point within the crossing portion 63. A second drill hole 66 is then formed in the planar wafer at the crossing portion 63. This process may be repeated as required to form as many additional drill holes 66 in the crossing portion 63 as required. Although the use of drilling produces discrete areas of weakness in the wafer 1, by restricting formation of the drill holes to the crossing portions 63, or by providing a greater line density of drill holes 66 in the crossing portions 63 than in intermediate portions 64 between the crossing portions 63, the average laser power applied per unit length will , as in previously described embodiments, be greater in the crossing portions 63 than in the intermediate portions 64.

In alternative embodiments, drill holes 66 may be produced not by drilling single holes 66 then relatively moving the wafer 1 and laser irradiation means, but instead by providing the laser irradiation means with a diffractive optical element ('DOE'), such that a laser beam produced by the laser source passes through the DOE and is split into a plurality of discrete, separated sub-beams. Each sub-beam is directed towards the wafer 1, and each sub-beam drills an individual hole. In this way, a plurality of drill holes will be simultaneously produced in the wafer 1, at a crossing portion, without relatively moving the wafer 1 and laser irradiation means. A relative movement between the wafer 1 and laser irradiation means will however be required to reproduce the plurality of drill holes at each crossing portion as required. The DOE could be configured to produce various arrays of drill-holes, such as a cruciform arrangement similar to that shown in FIG. 9, linear arrays etc.

In FIG. 9, in the outer area of the wafer 1, i.e. proximate to its outer edge in the region between the outer edge and the radially outermost device 2, irradiation lines 65 are fully formed, i.e. by scribing rather than drilling, using a relatively moving wafer 1 and laser source, since this aids separation without affecting the die strength in locations proximate any devices 2. This configuration is entirely optional though, and in other embodiments this outer area may not be so processed.

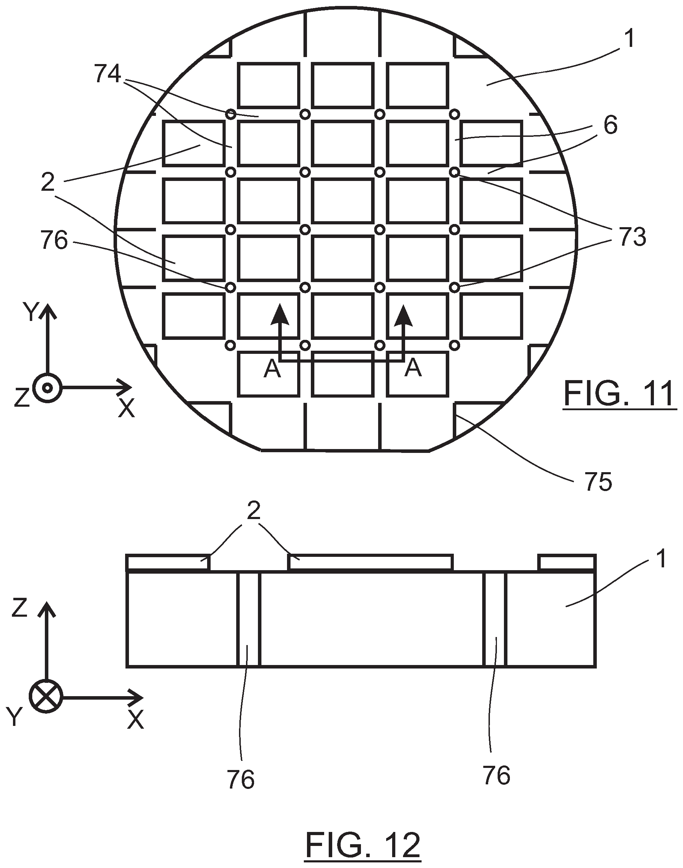

FIG. 11 schematically shows, from above, a wafer 1 which has been subjected to a process in accordance with a further embodiment of the present invention; and FIG. 12 schematically shows, from the side, a section of a wafer processed in accordance with the embodiment of FIG. 11. This embodiment may be considered a simplified version of that described above with reference to FIGs. 9 and 10. Here, the laser irradiation means is again used to create drill-holes 76 at crossing portions 73 located between intermediate portions 74 of channels 6 between devices 2. However, in this embodiment only a single drill-hole 76 is formed at each crossing portion 73. Since only a single drill-hole 76 is formed at each crossing portion 73, these are shown as being of relatively large diameter compared to the drill-holes 66 of FIGs. 9 and 10. However, the size of drill-hole 76 may be determined and configured as appropriate for the wafer 1 in question.

In FIG. 11, in the outer area of the wafer 1, i.e. proximate to its outer edge in the region between the outer edge and the radially outermost device 2, irradiation lines 75 are fully formed, i.e. by scribing rather than drilling, using a relatively moving wafer 1 and laser source, since this aids separation without affecting the die strength in locations proximate any devices 2. This configuration is entirely optional though, and in other embodiments this outer area may not be so processed.

The above-described embodiments are exemplary only, and other possibilities and alternatives within the scope of the invention will be apparent to those skilled in the art.

### REFERENCE NUMERALS:

1 - Wafer
2 - Devices
3 - Lines
4 - Flexible sheet
5 - Control means
6 - Channels
10 - Sub-surface dicing apparatus
11 - Laser source
12 - Laser beam
13 - First mirror
14 - Second mirror
15 - Beam shaper
16 - Sub-beams
17 - Focusing lenses
18 - Chuck
23, 23A-C, 45, 46A-C, 55, 65, 75 - Irradiation lines
33, 43, 53, 63, 73 - Crossing portions
44, 64, 74 - Intermediate portions
66, 76 - Drill holes

## Claims

1. A method of forming a plurality of lines of weakness, arranged in an orthogonal grid, in a planar wafer in preparation for a mechanical breaking step which breaks the wafer along the lines of weakness, the method comprising the steps of:
irradiating portions of the planar wafer with at least one laser beam, each portion coinciding with a line of weakness to be formed in the planar wafer, the portions comprising:
crossing portions which are located proximate intersections of the orthogonal grid, and
intermediate portions, which are located between adjacent crossing portions;
wherein the crossing portions are irradiated with a first average laser power, and
the intermediate portions are irradiated with a second average laser power; and
wherein the first average laser power is greater than the second average laser power.

2. The method of claim 1, comprising the steps of:
i) determining locations of the planar wafer at which the lines of weakness are to be formed and identifying a start location and an end location for each line of weakness;
ii) providing a laser irradiation means which is adapted to focus a laser beam to a focal point at the planar wafer;
iii) relatively moving the planar wafer and the laser irradiation means along a path parallel to the plane of the wafer from a position proximate the start location to a position proximate the end location;
wherein the path comprises alternating crossing portions and intermediate portions.

3. The method of claim 1, wherein the laser beam comprises a pulsed laser beam having a pulse period, each crossing portion is irradiated for a first time period, each intermediate portion is irradiated for a second time period, and both the first and second time periods are greater than the pulse period.

4. The method of claim 2, comprising repeating step iii) to form a plurality of lines of weakness in the planar wafer, the plurality of lines of weakness defining the orthogonal grid.

5. The method of claim 1, wherein the second average laser power is zero, so that the planar wafer is subjected to substantially no laser power at the intermediate portions.

6. The method of claim 2, wherein the laser irradiation means comprises a laser source to generate the laser beam, and step iii) comprises modulating the output power of the laser source to change the average laser power.

7. The method of claim 2, wherein the laser irradiation means comprises a laser source to generate the laser beam and a beam modulator interposed in an optical path of the generated laser beam between the laser source and the focal point, and step iii) comprises changing the average laser power of the generated laser beam, by controlling the beam modulator.

8. The method of claim 2, wherein step iii) comprises modulating the speed of relative movement between the planar wafer and the laser irradiation means, the speed of relative movement being lower along the first portion of the path than along the second portion of the path.

9. The method of claim 2, wherein step ii) comprises providing a laser irradiation means which is adapted to focus a laser beam to a focal point within the interior of the planar wafer, to create a sub-surface line of weakness in step iii),
and/or step ii) comprises providing a laser irradiation means which is adapted to focus a laser beam to a focal point proximate an upper surface of the wafer, to create a groove in the upper surface during step iii).

10. The method of claim 1, comprising the steps of:
i) providing a laser irradiation means which is adapted to direct a laser beam towards the planar wafer;
ii) positioning the planar wafer relative to the laser irradiation means so that the laser beam is directed towards a first point within a crossing portion; and
iii) drilling a hole into the planar wafer at the crossing portion with the laser beam.

11. The method of claim 10, comprising the further steps of:
iv) repositioning the planar wafer relative to the laser irradiation means so that the laser beam is directed towards a second point within the crossing portion; and
v) drilling a second hole into the planar wafer at the crossing portion with the laser beam;
and optionally comprising the steps of repositioning the planar wafer relative to the laser irradiation means so that the laser beam is directed towards an additional point within the crossing portion, and drilling an additional hole into the planar wafer at the crossing portion with the laser beam.

12. The method of claim 10, wherein step i) comprises providing the laser irradiation means with a diffractive optical element, and wherein the hole drilled in step iii) is one of a plurality of holes simultaneously drilled by directing the laser beam towards the planar wafer via the diffractive optical element.

13. A method of forming lines of weakness in a planar wafer having a plurality of devices formed thereon in a regular orthogonal array, the devices being spaced by channels, the method comprising:
irradiating the channels with at least one laser beam to weaken the planar wafer,
wherein portions of the channels which are proximate to intersections of the channels are irradiated with a first average laser power,
and portions of the channels which are intermediate the intersections are irradiated with a second average laser power; and
wherein the first average laser power is greater than the second average laser power.

14. A dicing machine for forming lines of weakness, arranged in an orthogonal grid, in a planar wafer, comprising:
a control means;
a laser irradiation means which is adapted to focus a laser beam towards the planar wafer; and
conveyance means for relatively moving the planar wafer and the laser irradiation means along a path parallel to the plane of the wafer;
wherein the control means is adapted to control the laser irradiation means and conveyance means to subject crossing portions of the planar wafer, which crossing portions are located proximate intersections of the orthogonal grid, to a first average laser power, and to subject intermediate portions of the planar wafer, which intermediate portions are located between adjacent crossing portions, to a second average laser power, and
wherein the first average laser power is greater than the second average laser power.

15. The dicing machine of claim 14, wherein the laser irradiation means comprises a laser source to generate the laser beam and a beam modulator interposed in an optical path of the generated laser beam between the laser source and the planar wafer in use, the beam modulator being controlled by the control means; optionally the beam modulator comprises a switchable beam shaper or a movable light barrier.
